# EUROPEAN PATENT APPLICATION

(11) **EP 4 420 831 A1**
(43) Date of publication of application: **28.08.2024**
(21) Application number: 22883428.9
(22) Date of filing: 12.10.2022
(51) Int. Cl.: B24B 21/08, B24B 21/00, B24B 41/06, H01L 21/304, H01L 21/677, H01L 21/683

(54) **SUBSTRATE PROCESSING APPARATUS**

(30) Priority: 20.10.2021 JP 2021171368
(71) Applicant: EBARA CORPORATION, Ota-ku, Tokyo 144-8510 (JP)
(72) Inventor: KOBAYASHI, Kenichi, Tokyo 144-8510 (JP); FUJISAWA, Mao, Tokyo 144-8510 (JP); KASHIWAGI, Makoto, Tokyo 144-8510 (JP)
(74) Representative: Schmidbauer, Andreas Konrad
(86) International application number: PCT/JP2022/037991
(87) International publication number: WO 2023/068124

(57) **Abstract**

The present invention relates to a substrate processing apparatus for processing a substrate, such as a wafer, and more particularly to a substrate processing apparatus for processing a surface of a substrate by pressing a processing tool against the surface of the substrate while holding a circumferential portion of the substrate with rotating rollers. The substrate processing apparatus includes a plurality of rollers (11A to 11D) arranged around a reference central point (CP) and configured to contact the circumferential portion of the substrate W, a processing tool (3) configured to press a pressing member (21A) against a periphery of the substrate W, and an actuator (22A) configured to apply a pressing force to the pressing member (21A). Two (11A, 11B) of the plurality of rollers (11A to 11D) are arranged adjacent to the pressing member (21A) and located at both sides of the pressing member (21A).

## Description

### Technical Field

The present invention relates to a substrate processing apparatus for processing a substrate, such as a wafer, and more particularly to a substrate processing apparatus for processing a surface of a substrate by pressing a processing tool against the surface of the substrate while holding a circumferential portion of the substrate with rotating rollers.

### Background Art

In recent years, devices, such as memory circuits, logic circuits, and image sensors (for example, CMOS sensors), are becoming more highly integrated. In the process of manufacturing these devices, foreign matter, such as fine particles and dust, may adhere to the devices. The foreign matter that has adhered to devices can cause short circuits between wires and can cause circuit malfunctions. Therefore, in order to improve reliability of the devices, it is necessary to clean a wafer on which devices are formed to remove foreign matter from the wafer.

Foreign matter, such as the above-mentioned fine particles and dust, may further adhere to a back surface (non-device surface) of the wafer. If such foreign matter adheres to the back surface of the wafer, the wafer may be separated from a stage reference plane of an exposure apparatus, causing the wafer surface to tilt with respect to the stage reference plane. As a result, patterning deviations and focal length deviations may occur. In order to prevent such problems, it is necessary to remove foreign matter from the back surface of the wafer.

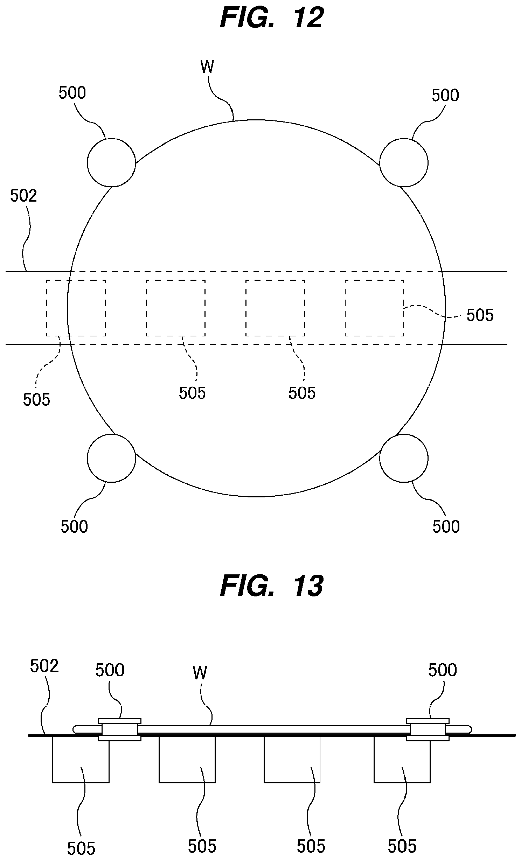

Therefore, as shown in FIGS. 12 and 13, a substrate processing apparatus is used to polish the back surface of the wafer with a polishing tape. FIG. 12 is a plan view of a conventional substrate processing apparatus, and FIG. 13 is a side view of the conventional substrate processing apparatus shown in FIG. 12. The substrate processing apparatus is configured to hold a circumferential portion of the wafer W with a plurality of rollers 500 and rotate these rollers 500 to thereby rotate the wafer W. A polishing tape 502 is placed on the back surface of the wafer W. A plurality of pressing members 505 are arranged in a diameter direction of the wafer W. These pressing members 505 press the polishing tape 502 against the back surface of the wafer W, thereby polishing the back surface of the wafer W. The polishing tape 502 pressed against the back surface of the wafer W can remove foreign matter from the back surface of the wafer W.

### Citation List

### Patent Literature

Patent document 1: Japanese laid-open patent publication No. 2019-77003

### Summary of Invention

### Technical Problem

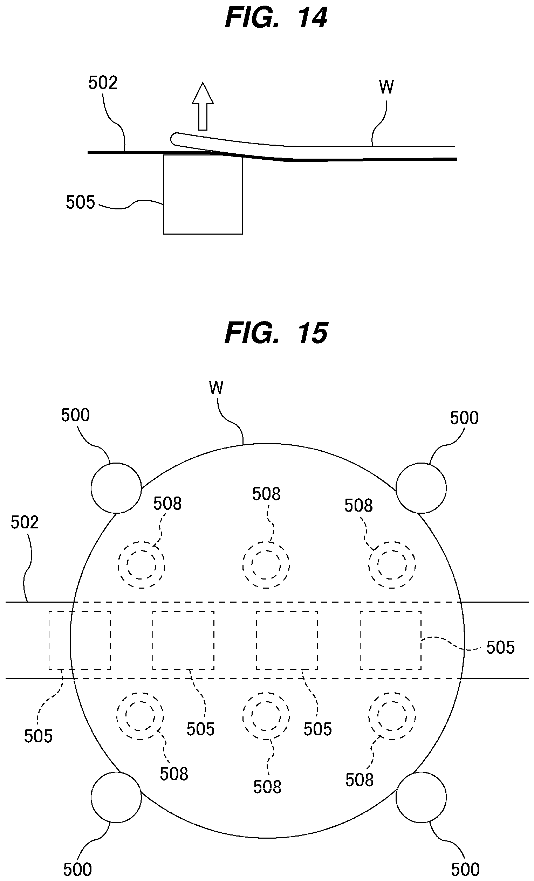

The circumferential portion of the wafer W has a larger area to be polished than a central portion of the wafer W. Therefore, in order to achieve a uniform polishing rate over the entire back surface of the wafer W, it is necessary to increase a polishing load applied to the circumferential portion of the wafer W from the outer pressing member 505. However, as shown in FIG. 14, when the polishing tape 502 is pressed against the circumferential portion of the wafer W with a large polishing load by the pressing member 505, the wafer W is bent upward. When the wafer W is bent in an arc shape, the polishing tape 502 is not pressed uniformly. As a result, the polishing rate of the circumferential portion of the wafer W becomes non-uniform.

In order to reduce such bending of the wafer W, one solution is to lower the polishing load of the outer pressing member 505. However, when the polishing load of the outer pressing member 505 is reduced, a polishing rate of an inner portion of the wafer W must also be reduced in order to make the polishing rate of the entire back surface of the wafer W uniform. As a result, the polishing rate of the entire back surface of the wafer W decreases, and it takes a longer polishing time to achieve a target polishing amount.

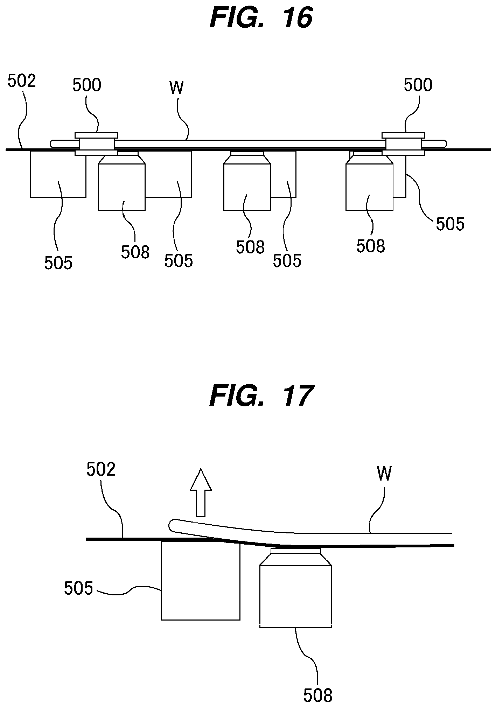

Therefore, in order to prevent the wafer W from bending upward, in one solution, Bernoulli chucks 508 are disposed on the back surface of the wafer W, as shown in FIGS. 15 and 16. Each Bernoulli chuck 508 is configured to generate suction force by discharging fluid and to attract the back surface of the wafer W downward. Such Bernoulli chucks 508 are expected to prevent the wafer W from bending upward.

However, since the Bernoulli chuck 508 is a certain distance from a polishing point of the wafer W, the wafer W still bends upward as shown in FIG. 17. One solution is to locate the Bernoulli chuck 508 closer to the polishing point of the wafer W, but due to the existence of the rotating rollers 500 and its drive mechanism, it is structurally difficult to locate the Bernoulli chuck 508 closer to the polishing point of the wafer W.

If the Bernoulli chuck 508 is made smaller, it is possible to locate the Bernoulli chuck 508 closer to the polishing point of the wafer W. However, when the Bernoulli chuck 508 becomes smaller, the suction force generated by the Bernoulli chuck 508 also decreases, making it unable to support the polishing load. As a result, the back surface of the wafer W separates from the Bernoulli chuck 508, and the Bernoulli chuck 508 is no longer able to perform its function.

Accordingly, the present invention provides a substrate processing apparatus that can process a substrate, such as a wafer, while reducing bending of the substrate due to a processing load on the substrate.

### Solution to Problem

In an embodiment, there is provided a substrate processing apparatus comprising: a plurality of rollers arranged around a reference central point and configured to contact a circumferential portion of the substrate; a pressing member configured to press a processing tool against a periphery of the surface of the substrate; and an actuator configured to apply a pressing force to the pressing member, wherein two of the plurality of rollers are adjacent to the pressing member and located at both sides of the pressing member.

In an embodiment, axes of the two rollers are on a reference perpendicular line or located more radially outward than the reference perpendicular line, the reference perpendicular line being perpendicular to a reference center line extending from the reference central point to a center of the pressing member, the reference perpendicular line extending through the center of the pressing member.

In an embodiment, the substrate processing apparatus further comprises a Bernoulli chuck configured to support the surface of the substrate via fluid in a non-contact manner, a central angle between the reference center line and a line extending from the reference central point to the axis of each of the two rollers being smaller than a central angle between the reference center line and a line extending from the reference central point to a center of the Bernoulli chuck.

In an embodiment, the two rollers have a different shape from other rollers of the plurality of rollers.

In an embodiment, each of the two rollers has a tapered surface in a shape of an inverted truncated cone and is configured to apply a reaction force against the pressing force to the circumferential portion of the substrate.

In an embodiment, the plurality of rollers have the same shape and are configured to hold the circumferential portion of the substrate.

### Advantageous Effects of Invention

The two rollers arranged at both sides of the pressing member can support the pressing force applied from the pressing member to the circumferential portion of the substrate, and can significantly reduce upward bending of the substrate. As a result, the processing head can uniformly press the processing tool against the circumferential portion of the substrate with an intended pressing force, so that a target removal rate can be achieved. Furthermore, a uniform removal rate can be achieved over the entire polished surface of the substrate.

### Brief Description of Drawings

[FIG. 1] FIG. 1 is a side view showing an embodiment of a substrate processing apparatus;
[FIG. 2] FIG. 2 is a plan view of the substrate processing apparatus shown in FIG. 1;
[FIG. 3] FIG. 3 is a side view showing a roller;
[FIG. 4] FIG. 4 is a cross-sectional view showing one embodiment of a Bernoulli chuck;
[FIG. 5] FIG. 5 is a diagram showing a positional relationship between rollers arranged at both sides of a pressing member and Bernoulli chucks located closest to these rollers;
[FIG. 6] FIG. 6 is a side view showing another embodiment of the substrate processing apparatus;
[FIG. 7] FIG. 7 is a plan view of the substrate processing apparatus shown in FIG. 6;
[FIG. 8] FIG. 8 is a side view showing a second roller in contact with a circumferential portion of a substrate;
[FIG. 9] FIG. 9 is a side view showing still another embodiment of the substrate processing apparatus;
[FIG. 10] FIG. 10 is a side view showing still another embodiment of the substrate processing apparatus;
[FIG. 11] FIG. 11 is a plan view of the substrate processing apparatus shown in FIG. 10; [FIG. 12] FIG. 12 is a plan view showing an example of a conventional substrate processing apparatus;
[FIG. 13] FIG. 13 is a side view of the conventional substrate processing apparatus shown in FIG. 12;
[FIG. 14] FIG. 14 is a side view illustrating a substrate when bending upward;
[FIG. 15] FIG. 15 is a plan view showing another example of a conventional substrate processing apparatus;
[FIG. 16] FIG. 16 is a side view of the conventional substrate processing apparatus shown in FIG. 14; and
[FIG. 17] FIG. 17 is a side view illustrating a substrate when bending upward.

### Description of Embodiments

Embodiments of the present invention will be described below with reference to the drawings.

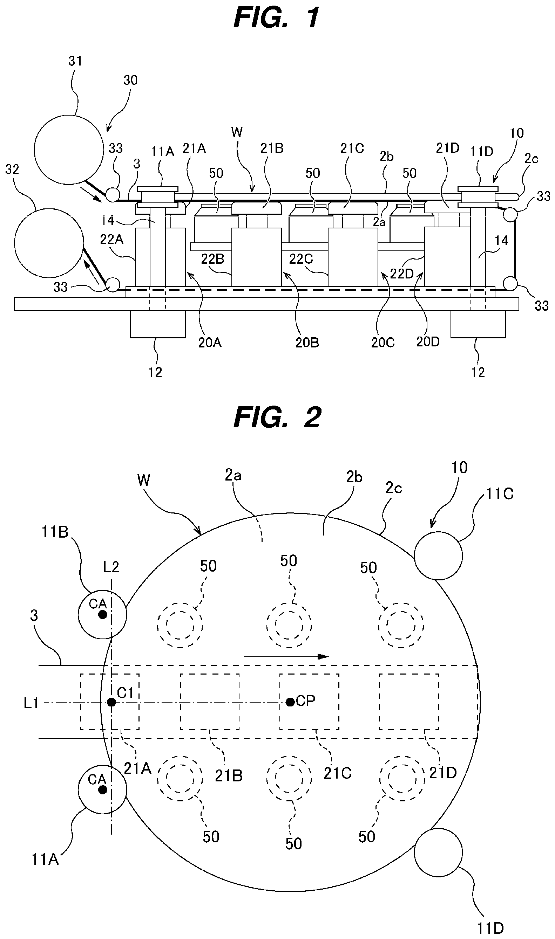

FIG. 1 is a side view showing an embodiment of a substrate processing apparatus, and FIG. 2 is a plan view of the substrate processing apparatus shown in FIG. 1. The substrate processing apparatus shown in FIG. 1 includes a substrate holder 10 configured to hold a substrate W and rotate the substrate W about a reference central point CP, a plurality of processing heads 20A to 20D each configured to process (polish) a first surface 2a of the substrate W by bringing a polishing tape 3 as a processing tool into contact with the first surface 2a of the substrate W held by the substrate holder 10, and polishing-tape supply mechanism 30 configured to supply the polishing tape 3 to the processing heads 20A to 20D and collect the polishing tape 3 from the processing heads 20A to 20D. Each of the processing heads 20A to 20D is an example of a processing head that processes the surface of the substrate W.

In this embodiment, the first surface 2a of the substrate W is a back surface of the substrate W on which no device is formed or where no device is to be formed, i.e., a non-device surface. A second surface 2b of the substrate W opposite to the first surface 2a is a surface on which devices are formed or devices are to be formed, i.e., a device surface. In this embodiment, the substrate W is supported horizontally by the substrate holder 10 with the first surface 2a facing downward.

The substrate holder 10 includes a plurality of rollers 11A to 11D configured to be able to contact a circumferential portion 2c of the substrate W, and a plurality of roller rotating devices 12 configured to rotate the rollers 11A to 11D, respectively. The plurality of rollers 11A to 11D are coupled to the corresponding roller rotating devices 12 via a plurality of rotation shafts 14 (only two roller rotating devices 12 and only two rotation shafts 14 are shown in FIG. 1). The plurality of rollers 11A to 11D are arranged around a reference central point CP. Each roller rotating device 12 includes an electric motor, such as a servo motor, and the plurality of roller rotating devices 12 are configured to synchronize and rotate the plurality of rollers 11A to 11D at the same speed. In one embodiment, a single roller rotating device may be provided to transmit torque to the multiple rollers 11A to 11D via a synchronous belt to cause the rollers 11A to 11D to rotate at the same speed. In this embodiment, four rollers 11A to 11D are provided, while five or more rollers may be provided.

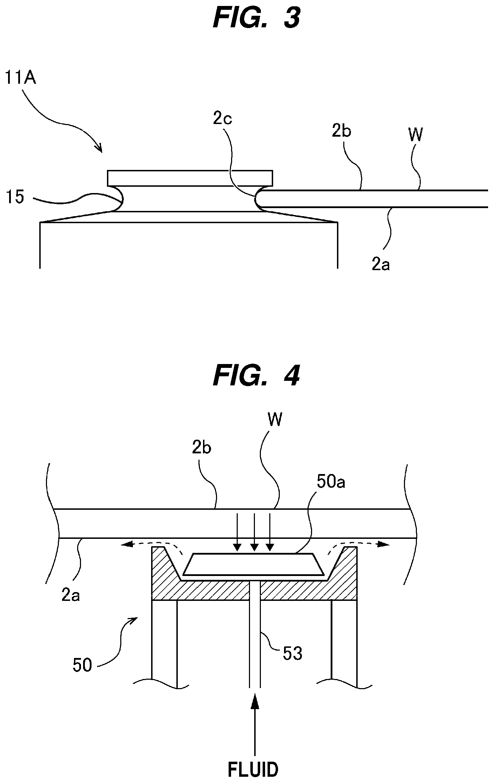

Since the rollers 11A to 11D have the same shape, the roller 11A will be described below with reference to FIG. 3. FIG. 3 is a side view showing the roller 11A. The roller 11A has a substrate holding surface 15 configured to be able to come into contact with the circumferential portion 2c of the substrate W. The circumferential portion 2c of the substrate W is an outermost annular curved surface of the substrate W, and is coupled to both a periphery of the first surface 2a and a periphery of the second surface 2b. The circumferential portion 2c may also be called a bevel portion. The substrate holding surface 15 has an inwardly constricted cylindrical shape. The substrate holding surface 15 having such a shape can limit inclination of the substrate W, a height of the substrate W, and a movement of the substrate W in a vertical direction during processing of the substrate W.

As shown in FIGS. 1 and 2, the plurality of processing heads 20A to 20D are arranged under the substrate W held by the substrate holder 10. These processing heads 20A to 20D are arranged in a diameter direction of the substrate W. In this embodiment, four processing heads 20A to 20D are provided, while the number of processing heads is not limited to this embodiment.

The processing head 20A includes a pressing member 21A configured to press the polishing tape 3 against the first surface 2a of the substrate W, and an actuator 22A configured to apply a pressing force to the pressing member 21A. The actuator 22A pushes up the pressing member 21A to cause the pressing member 21A to press the polishing tape 3 against the first surface 2a of the substrate W from the back side of the polishing tape 3 to thereby process (polish) the first surface 2a of the substrate W.

The processing heads 20B to 20D have the same configuration as the processing head 20A. Specifically, the processing heads 20B to 20D include pressing members 21B to 21D configured to press the polishing tape 3 against the first surface 2a of the substrate W, and actuators 22B to 22D configured to apply pressing force to the pressing member 21A.

The polishing-tape supply mechanism 30 includes a tape feeding reel 31 to which one end of the polishing tape 3 is coupled, a tape take-up reel 32 to which the other end of the polishing tape 3 is coupled, and a plurality of guide rollers 33 arranged to guide an advancing direction of the polishing tape 3. The polishing tape 3 advances from the tape feeding reel 31 to the tape take-up reel 32 via the processing heads 20A to 20D.

The tape feeding reel 31 and the tape take-up reel 32 are coupled to reel motors (not shown), respectively. These reel motors apply torques for rotating the tape feeding reel 31 and the tape take-up reel 32 in opposite directions, thereby generating a tension in the polishing tape 3. The torque applied to the tape take-up reel 32 is greater than the torque applied to the tape feeding reel 31. During polishing of the substrate W, the tape take-up reel 32 is rotated by the reel motor, so that the tension is applied to the polishing tape 3, and the polishing tape 3 is advanced from the tape feeding reel 31 to the take-up reel 32 via the processing heads 20A to 20D.

In one embodiment, a tape advancing device for advancing the polishing tape 3 in its longitudinal direction may be provided in addition to the tape feeding reel 31, the tape take-up reel 32, and the reel motors. In still another embodiment, positions of tape feeding reel 31 and tape take-up reel 32 may be reversed.

The substrate processing apparatus further includes a plurality of Bernoulli chucks 50 configured to support the first surface (lower surface) 2a of the substrate W in a non-contact manner through fluid. These Bernoulli chucks 50, as well as the processing heads 20A to 20D, are arranged under the first surface 2a of the substrate W held by the substrate holder 10, and are arranged so as to face the first surface 2a. These Bernoulli chucks 50 are arranged adjacent to the pressing members 21A to 21D of the plurality of processing heads 20A to 20D. In the example shown in FIG. 2, six Bernoulli chucks 50 are arranged at both sides of the polishing tape 3, while the number and arrangement of Bernoulli chucks 50 are not limited to the example shown in FIG. 2.

FIG. 4 is a cross-sectional view showing one embodiment of the Bernoulli chuck 50. As shown in FIG. 4, each Bernoulli chuck 50 has a suction surface 50a facing the first surface 2a of the substrate W held by the substrate holder 10. A fluid supply line 53 is coupled to the Bernoulli chuck 50 for supplying fluid (for example, gas, such as dry air, inert gas, or liquid, such as pure water) around the suction surface 50a. The fluid flows through the fluid supply line 53 and is discharged outward from an outer periphery of the suction surface 50a, thereby forming negative pressure in a space between the suction surface 50a and the first surface 2a of the substrate W. Therefore, the Bernoulli chuck 50 can attract the first surface 2a of the substrate W. Since the flow of fluid is formed in a gap between the outer periphery of the suction surface 50a and the first surface 2a of the substrate W, the Bernoulli chuck 50 does not come into contact with the substrate W. Therefore, the rollers 11A to 11D of the substrate holder 10 can rotate the substrate W, while the Bernoulli chuck 50 supports the first surface 2a of the substrate W in a non-contact manner.

As shown in FIGS. 1 and 2, when the polishing tape 31 is pressed against the first surface 2a of the substrate W to polish the first surface 2a of the substrate W, the pressing members 21A to 21D apply upward processing loads to the substrate W. In this embodiment, the substrate W is subjected to downward suction forces by the Bernoulli chucks 50. Such downward suction forces cancel the upward processing loads applied to the substrate W. Therefore, the Bernoulli chucks 50 can reduce bending of the substrate W.

However, the outermost pressing member 21A is arranged more radially outward than the Bernoulli chuck 50. In addition, in order to make a removal rate of the substrate W uniform over the entire first surface 2a, the outermost pressing member 21A presses the polishing tape 3 against the substrate W with a larger pressing force than those of the other pressing members 21B to 21D. As a result, the circumferential portion of the substrate W is likely to be bent by the pressing force applied by the outermost pressing member 21A.

Therefore, in order to receive the pressing force applied by the pressing member 21A, two rollers 11A and 11B among the rollers 11A to 11D are arranged adjacent to the pressing member 21A and are located at both sides of the pressing member 21A. The both sides of the pressing member 21A mean both sides of the pressing member 21A in the circumferential direction of the substrate W. In particular, in this embodiment, as shown in FIG. 2, axial centers CA of the two rollers 11A and 11B are located on a reference perpendicular line L2 or located more radially outward than the reference perpendicular line L2. The reference perpendicular line L2 is perpendicular to a reference center line L1 extending from the reference central point CP to a center C1 of the pressing member 21A, and passes through the center C1 of the pressing member 21A. In the embodiment shown in FIG. 2, the axial centers CA of the two rollers 11A and 11B are located more radially outward than the reference perpendicular line L2.

The two rollers 11A and 11B arranged in these locations can support the pressing force applied from the pressing member 21A of the processing head 20A to the periphery of the first surface 2a of the substrate W, and can therefore significantly reduce the upward bending of the substrate W. As a result, the processing head 20A can uniformly apply the polishing tape 3 to the periphery of the first surface 2a of the substrate W with an intended pressing force, and a target removal rate can be achieved. Furthermore, a uniform removal rate can be achieved over the entire first surface 2a of the substrate W.

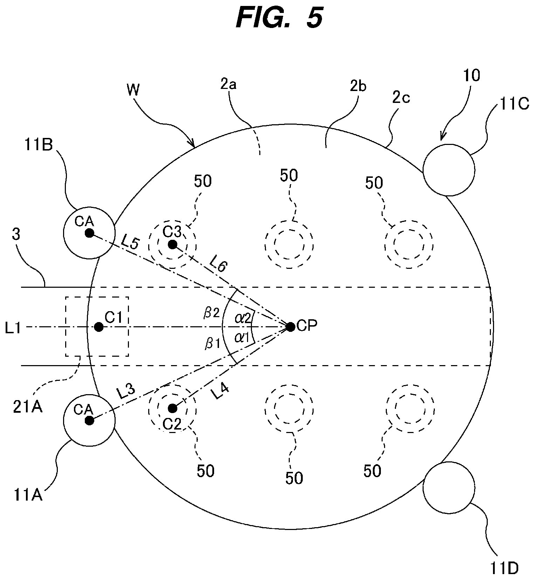

FIG. 5 is a diagram showing a positional relationship between the rollers 11A and 11B arranged at both sides of the pressing member 21A and the Bernoulli chucks 50 located closest to these rollers 11A and 11B. In FIG. 5, illustration of the pressing members 21B to 21D is omitted for ease of understanding.

As shown in FIG. 5, a central angle α1 between the reference center line L1 and a line L3 extending from the reference central point CP to the axis CA of the roller 11A is smaller than a central angle β1 between the reference center line L1 and a line L4 extending from the reference central point CP to a center C2 of the Bernoulli chuck 50 that is closest to the roller 11A. Similarly, a central angle α2 between the reference center line L1 and a line L5 extending from the reference central point CP to the axis CA of the roller 11B is smaller than a central angle β2 between the reference center line L1 and a line L6 extending from the reference central point CP to a center C3 of the Bernoulli chuck 50 that is closest to the roller 11B.

Since the pressing member 21A is located closer to the two rollers 11A and 11B than to the Bernoulli chucks 50, the two rollers 11A and 11B can work together with the Bernoulli chucks 50 to significantly reduce the upward deflection of the substrate W.

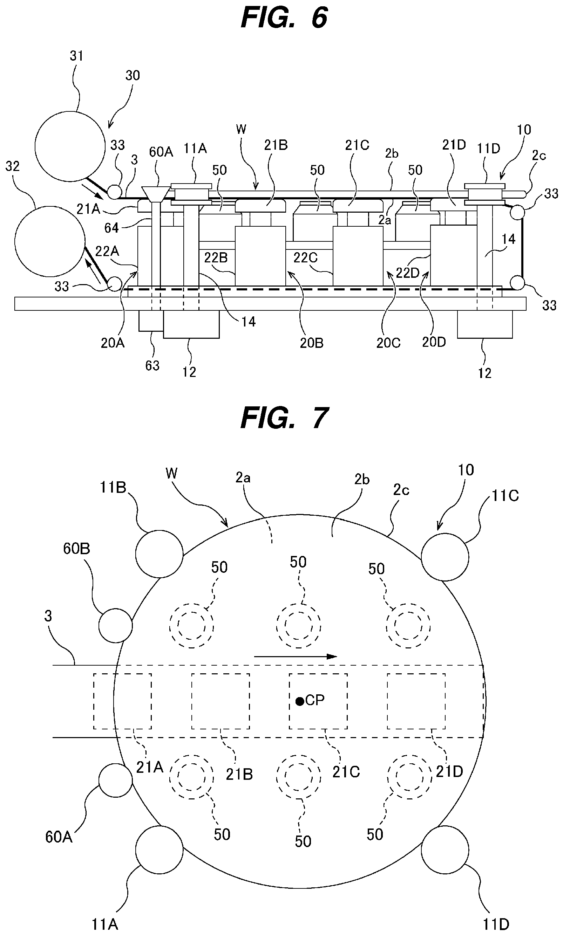

FIG. 6 is a side view showing another embodiment of the substrate processing apparatus, and FIG. 7 is a plan view of the substrate processing apparatus shown in FIG. 6. Configuration and operation of this embodiment, which are not particularly described, are the same as those of the embodiments described with reference to FIGS. 1 to 5, and therefore, redundant descriptions thereof will be omitted. As shown in FIGS. 6 and 7, in this embodiment, two rollers 60A and 60B that contact the circumferential portion 2c of the substrate W are provided in addition to the rollers 11A to 11D. In the following description, the rollers 11A to 11D are referred to as first rollers 11A to 11D, and the two rollers 60A and 60B are referred to as second rollers 60A and 60B. The first rollers 11A to 11D and the second rollers 60A and 60B are arranged around the reference central point CP.

The first rollers 11A to 11D are provided for the purpose of applying torque to the substrate W to rotate the substrate W. The first rollers 11A to 11D are arranged at equal intervals around the reference central point CP. In this embodiment, four first rollers 11A to 11D are provided, while five or more first rollers may be provided.

The two second rollers 60A and 60B are provided for the purpose of supporting the pressing force applied to the substrate W from the pressing member 21A and reducing the bending of the substrate W. The two second rollers 60A and 60B have a different shape from the shape of the first rollers 11A to 11D. The second rollers 60A, 60B are arranged adjacent to the pressing member 21A and located at both sides of the pressing member 21A. The arrangement of the second rollers 60A, 60B is the same as the arrangement of the two rollers 11A, 11B described with reference to FIGS. 2 and 5, and therefore redundant explanations of the arrangement of the second rollers 60A, 60B will be omitted.

The two second rollers 60A, 60B are coupled to two corresponding second roller rotating devices 63, respectively, via two rotation shafts 64 (in FIG. 6, only one second roller rotating device 63 and only one rotation axis 64 are depicted). The second roller rotating devices 63 operate in synchronization with the first roller rotating devices 12 that rotates the first rollers 11A to 11D. Specifically, the second roller rotating devices 63 rotate the second rollers 60A and 60B such that a circumferential speed of the second rollers 60A and 60B is the same as a circumferential speed of the first rollers 11A to 11D. Since the second rollers 60A, 60B are rotated by the second roller rotating devices 63, friction between the second rollers 60A, 60B and the circumferential portion of the substrate W can be reduced, and generation of particles due to the friction can be prevented. Depending on material of the second rollers 60A, 60B, the second rollers 60A, 60B may be configured to freely rotate without the second roller rotating devices 63. In this case, the second rollers 60A, 60B are rotated by contact with the circumferential portion 2c of the substrate W.

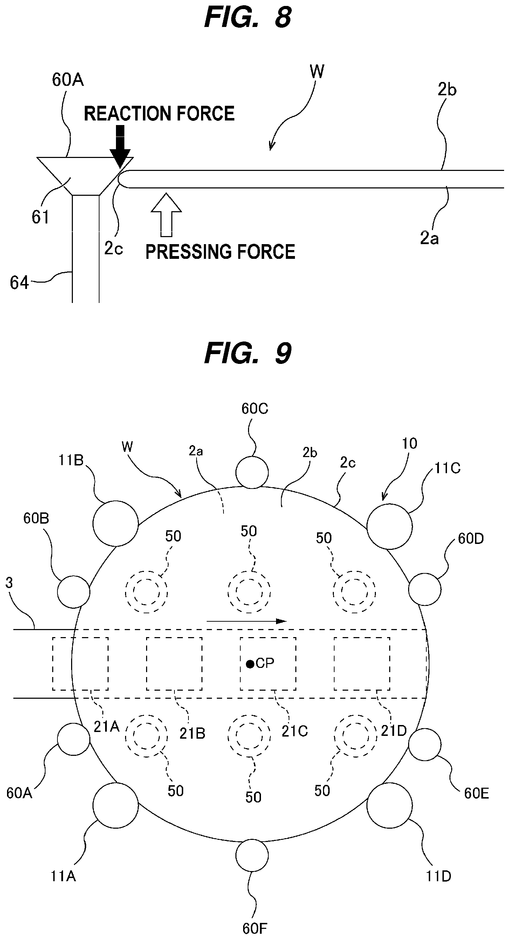

Since the second rollers 60A and 60B have the same shape, the second roller 60A will be described below with reference to FIG. 8. FIG. 8 is a side view showing the second roller 60A in contact with the circumferential portion 2c of the substrate W. As shown in FIG. 8, the second roller 60A has a tapered surface 61 in a shape of an inverted truncated cone, and is configured to apply a reaction force to the circumferential portion 2c of the substrate W against the pressing force generated by the processing head 20A. In the example shown in FIG. 8, the tapered surface 61 of the second roller 60A faces downward as a whole, and the second roller 60A applies the downward reaction force to the circumferential portion 2c of the substrate W.

The second rollers 60A and 60B arranged in these locations can support the pressing force applied to the periphery of the first surface 2a of the substrate W from the pressing member 21A of the processing head 20A, and can significantly reduce the upward bending of the substrate W. As a result, the processing head 20A can uniformly press the polishing tape 3 against the periphery of the first surface 2a of the substrate W with an intended pressing force, and the target removal rate can be achieved. Furthermore, a uniform removal rate can be achieved over the entire first surface 2a of the substrate W.

In addition to the two second rollers 60A, 60B, at least one second roller may further be provided between the first rollers 11A to 11D. For example, as shown in FIG. 9, at least one second roller (denoted by reference numerals 60A to 60F) may be arranged between adjacent two of the first rollers 11A to 11D. By alternately arranging the first rollers 11A to 11D and the second rollers 60A to 60F in this way, the suction force required for the Bernoulli chucks 50 can be reduced, and as a result, the amount of fluid supplied to the Bernoulli chucks 50 can be reduced.

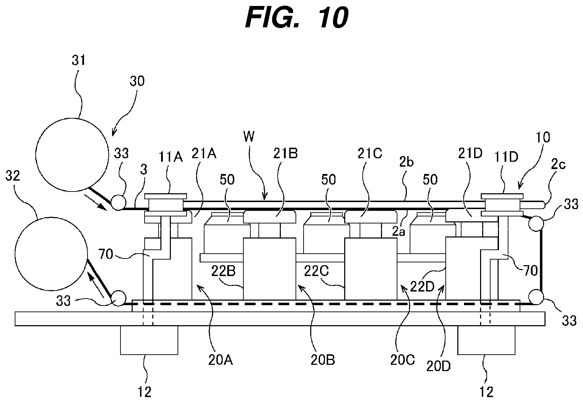

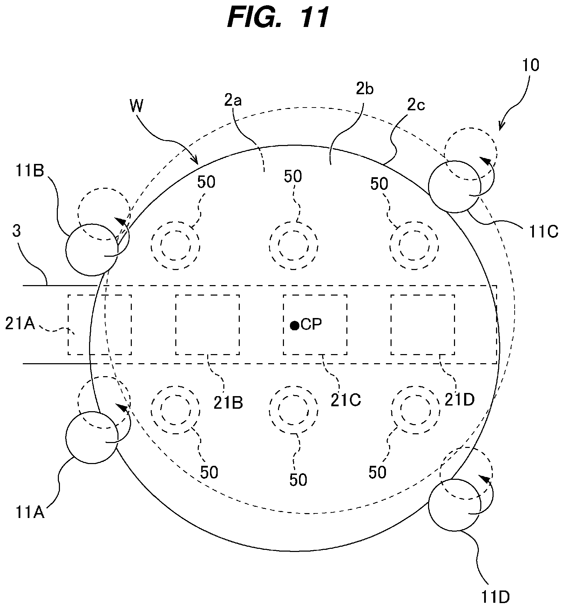

The substrate processing apparatus of the embodiments described so far is configured to rotate the rollers 11A to 11D (and the second rollers 60A to 60F) around their axes. The invention can be applied to a substrate processing apparatus in which the rollers 11A to 11D (and the second rollers 60A to 60F) make orbital motions. Specifically, as shown in FIGS. 10 and 11, the rollers 11A to 11D (and the second rollers 60A to 60F) may be coupled to the corresponding roller rotating device 12 via eccentric shafts 70. The rollers 11A to 11D (and the second rollers 60A to 60F) are fixed to the corresponding eccentric shafts 70. According to this configuration, the rollers 11A to 11D (and the second rollers 60A to 60F) rotate around their own centers while moving in circular orbits, and the substrate W also rotates around its own center while moving in a circular orbit. The embodiments described with reference to FIGS. 1 to 8 can be applied to the embodiment shown in FIGS. 10 and 11 as well.

In each of the embodiments described above, the polishing tape is used as the processing tool, while a whetstone, a cleaning tape, a nonwoven tape, a cleaning pad, or the like may be used instead of the polishing tape.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a substrate processing apparatus for processing a substrate, such as a wafer, and more particularly to a substrate processing apparatus for processing a surface of a substrate by pressing a processing tool against the surface of the substrate while holding a circumferential portion of the substrate with rotating rollers.

### Reference Signs List

W substrate
2a first surface
2b second surface
2c circumferential portion
3 polishing tape (processing tool)
10 substrate holder
11A-11D roller
12 roller rotating device
14 rotation shaft
15 substrate holding surface
20A-20D processing head
21A-21D pressing member
22A-22D actuator
30 polishing-tape supply mechanism
31 tape feeding reel
32 tape take-up reel
33 guide roller
50 Bernoulli chuck
50a suction surface
53 fluid supply line
60A-60F second roller
61 tapered surface
63 second roller rotating device
64 rotation shaft
70 eccentric shaft

## Claims

1. A substrate processing apparatus comprising:
a plurality of rollers arranged around a reference central point and configured to contact a circumferential portion of the substrate;
a pressing member configured to press a processing tool against a periphery of the surface of the substrate; and
an actuator configured to apply a pressing force to the pressing member,
wherein two of the plurality of rollers are adjacent to the pressing member and located at both sides of the pressing member.

2. The substrate processing apparatus according to claim 1, wherein axes of the two rollers are on a reference perpendicular line or located more radially outward than the reference perpendicular line, the reference perpendicular line being perpendicular to a reference center line extending from the reference central point to a center of the pressing member, the reference perpendicular line extending through the center of the pressing member.

3. The substrate processing apparatus according to claim 1 or 2, further comprising a Bernoulli chuck configured to support the surface of the substrate via fluid in a non-contact manner, a central angle between the reference center line and a line extending from the reference central point to the axis of each of the two rollers being smaller than a central angle between the reference center line and a line extending from the reference central point to a center of the Bernoulli chuck.

4. The substrate processing apparatus according to any one of claims 1 to 3, wherein the two rollers have a different shape from other rollers of the plurality of rollers.

5. The substrate processing apparatus according to claim 4, wherein each of the two rollers has a tapered surface in a shape of an inverted truncated cone and is configured to apply a reaction force against the pressing force to the circumferential portion of the substrate.

6. The substrate processing apparatus according to any one of claims 1 to 3, wherein the plurality of rollers have the same shape and are configured to hold the circumferential portion of the substrate.
